# FASCICULE DE BREVET EUROPEEN

(11) **EP 2 849 196 B1**
(45) Date de publication et mention de la délivrance du brevet: **23.03.2016**
(21) Numéro de dépôt: 14184407.6
(22) Date de dépôt: 11.09.2014
(51) Int. Cl.: H01H 71/04, H02H 3/38, H01H 71/46, G01R 19/00, G01R 19/25, G01R 31/08, H02H 3/08, H02H 3/10, H02H 3/24, H02H 5/04

(54) **Procédé de détermination d'une cause de perte de tension en aval d'un disjoncteur, appareil auxiliaire pour disjoncteur, système électrique comportant un disjoncteur et un tel appareil auxiliaire**
Verfahren zur Erkennung der Ursache eines Spannungsverlusts vor einem Trennschalter, Hilfsgerät für Trennschalter sowie elektrisches System, das einen solchen Trennschalter und ein solches Hilfsgerät umfasst
Method for determining a cause of a loss of voltage downstream from a circuit breaker, auxiliary apparatus for a circuit breaker, electric system comprising a circuit breaker and such an auxiliary apparatus

(30) Priorité: 12.09.2013 FR 1358776
(43) Date de publication de la demande: 18.03.2015
(73) Titulaire: Schneider Electric Industries SAS, 92500 Rueil-Malmaison (FR)
(72) Inventeur: Vincent, François, 38050 Grenoble Cedex 09 (FR); Tian, Simon, 38050 Grenoble Cedex 09 (FR)
(74) Mandataire: Myon, Gérard Jean-Pierre

(56) Documents cités:
- EP-A2- 1 755 135
- EP-A2- 2 355 121
- WO-A1-99/46868
- US-A1- 2008 136 567

## Description

La présente invention concerne un procédé de détermination d'une cause de perte de tension en aval d'un disjoncteur à l'aide d'un appareil auxiliaire, l'absence de tension en aval du disjoncteur correspondant à une ouverture du disjoncteur ou à une chute de tension en entrée du disjoncteur en dessous d'une première valeur de tension de référence.

La présente invention concerne également un appareil auxiliaire pour disjoncteur électrique, le disjoncteur étant, en position ouverte, propre à interrompre la circulation d'un courant électrique dans une liaison électrique comprenant au moins un conducteur électrique.

La présente invention concerne également un système électrique comprenant un disjoncteur électrique et un tel appareil auxiliaire couplé au disjoncteur électrique.

Un enjeu persistant dans le domaine des disjoncteurs est d'identifier, suite à l'ouverture du disjoncteur, le type de défaillance ayant causé cette ouverture.

Il est ainsi connu de EP-A1-1065691 d'utiliser un module auxiliaire de signalisation pour disjoncteur comprenant un premier commutateur indiquant l'état fermé ou ouvert des contacts du disjoncteur et un deuxième commutateur indiquant l'état armé ou déclenché du disjoncteur. Ainsi, une fois le module auxiliaire accouplé au disjoncteur, les commutateurs sont propres à interférer avec le mécanisme du disjoncteur et à être déplacés suivant l'état du disjoncteur. Un tel module auxiliaire permet donc de savoir si le disjoncteur est ouvert suite à un actionnement manuel de l'ouverture du disjoncteur, l'état du disjoncteur étant alors également appelé état ouvert, ou bien suite à la présence d'un défaut, tel qu'une surcharge électrique sur la liaison électrique, ayant provoqué le déclenchement du disjoncteur, l'état du disjoncteur étant également appelé état déclenché sur défaut. Lorsque le disjoncteur est en position de fermeture, l'état du disjoncteur est également appelé état fermé.

Cependant, un tel module auxiliaire pour disjoncteur permet de connaitre seulement l'état du disjoncteur parmi les états ouvert, fermé, ou déclenché sur défaut, et ne permet pas de connaitre précisément une cause du déclenchement du disjoncteur électrique, c'est-à-dire une cause de l'état déclenché du disjoncteur. Le but de l'invention est donc de proposer un appareil auxiliaire pour disjoncteur électrique et un procédé associé permettant une surveillance optimale du disjoncteur électrique et notamment la détermination de la cause d'une ouverture du disjoncteur électrique auquel l'appareil auxiliaire est couplé.

EP-A-2355121 décrit un procédé de détermination d'une cause de perte de tension en aval d'un disjoncteur à l'aide d'un appareil auxiliaire, l'appareil auxiliaire comprenant un premier moyen de détection propre à détecter la perte de tension en aval du disjoncteur.

EP-A-2355121 décrit aussi un appareil auxiliaire pour disjoncteur électrique, l'appareil auxiliaire comprenant un premier moyen de détection propre à détecter une perte de tension en aval du disjoncteur, la perte de tension en aval correspondant à une chute de tension en entrée du disjoncteur en dessous d'une première valeur de tension de référence. L'invention a pour objet un procédé de détermination d'une cause de perte de tension en aval d'un disjoncteur à l'aide d'un appareil auxiliaire, la perte de tension en aval du disjoncteur correspondant à une ouverture du disjoncteur ou à une chute de tension en entrée du disjoncteur en dessous d'une première valeur de tension de référence, le disjoncteur étant, en position ouverte, propre à interrompre la circulation d'un courant électrique dans une liaison électrique comportant au moins un conducteur électrique, l'appareil auxiliaire comprenant au moins un capteur de courant propre à mesurer l'intensité du courant circulant dans un conducteur électrique respectif et un premier moyen de détection propre à détecter la perte de tension en aval du disjoncteur, le procédé comprenant les étapes suivantes :
- a) la mesure, par le ou chaque capteur de courant, de l'intensité du courant circulant dans le ou chaque conducteur électrique,
- b) la détection, via le premier moyen de détection, de la perte de tension en aval du disjoncteur.
   Conformément à l'invention le procédé comprend en outre l'étape suivante :
- c) la détermination, par l'appareil auxiliaire et en fonction de l'intensité mesurée par le ou chaque capteur de courant, d'une cause de la perte de tension détectée, ladite cause étant de préférence choisie parmi le groupe consistant en : une surcharge électrique, un court-circuit, et une chute de tension.

Grâce à l'invention, l'appareil auxiliaire est propre à diagnostiquer précisément la cause de la perte de tension en aval du disjoncteur en fonction de la mesure du courant circulant dans le ou chaque conducteur électrique correspondant. Ainsi, grâce à la mesure du courant, le dispositif de détermination est, par exemple, propre à déterminer si la perte de tension en aval du disjoncteur est due à une chute de tension ou à un court-circuit ou encore à un courant de surcharge.

Selon différents aspects de l'invention, le procédé de détermination d'une cause de la perte de tension en aval du disjoncteur comprend une ou plusieurs des caractéristiques suivantes, prises isolément ou suivant toutes les combinaisons techniquement admissibles :
- suite à l'étape a) de mesure et précédemment à l'étape b) de détection, l'appareil auxiliaire réalise l'étape suivante :
   - a2) le calcul, en fonction des valeurs d'intensité mesurées à l'étape a), d'un échauffement d'un ou de deuxièmes moyens de détection d'une surcharge électrique, le ou les deuxièmes moyens de détection étant compris dans le disjoncteur ;
- suite à l'étape a2) l'appareil auxiliaire réalise les étapes suivantes :
   - a3) la comparaison de la valeur de l'échauffement calculée avec une première valeur de seuil, et
   - a4) la génération d'un signal d'alarme lorsque la valeur de l'échauffement calculée est supérieure à la première valeur de seuil ;
- suite à l'étape a2) l'appareil auxiliaire réalise les étapes suivantes :
   - a3') la comparaison de la valeur de l'échauffement calculée avec une première valeur de seuil et avec une deuxième valeur de seuil, inférieure à la première valeur de seuil, et
   - a4') la génération d'un signal d'alarme à partir du moment où la valeur de l'échauffement calculée est supérieure à la première valeur de seuil et tant que la valeur de l'échauffement calculée est supérieure à la deuxième valeur de seuil ;
- suite à l'étape b) de détection, si la perte de tension en aval du disjoncteur a été détectée par le premier moyen de détection, l'appareil auxiliaire réalise au cours de l'étape c) de détermination l'étape suivante :
   - c1) la comparaison de la valeur de l'échauffement calculée avec une troisième valeur de seuil afin de détecter une première cause de la perte de tension en aval du disjoncteur, la troisième valeur de seuil étant supérieure à la première valeur de seuil ;
- suite à l'étape a) de mesure et précédemment à l'étape b) de détection, l'appareil auxiliaire réalise l'étape suivante :
   - a5) le calcul d'une valeur maximale des intensités mesurées pendant un laps de temps prédéterminé ;
- suite à l'étape b) de détection, si la perte de tension en aval du disjoncteur a été détectée par le premier moyen de détection, l'appareil auxiliaire réalise au cours de l'étape c) de détermination l'étape suivante :
   - c2) la comparaison de la valeur maximale du courant avec une quatrième valeur de seuil, afin de détecter une deuxième cause de la perte de tension en aval du disjoncteur ;
- suite à l'étape c) de détermination, l'appareil auxiliaire effectue l'étape suivante :
   - d) la transmission d'un message contenant une première donnée correspondant à la présence de tension en aval du disjoncteur et une deuxième donnée correspondant à la cause de la perte de tension en aval du disjoncteur, vers un concentrateur.

L'invention a également pour objet un appareil auxiliaire pour disjoncteur électrique, le disjoncteur étant, en position ouverte, propre à interrompre la circulation d'un courant électrique dans une liaison électrique comportant au moins un conducteur électrique, l'appareil auxiliaire comprenant au moins un capteur de courant propre à mesurer l'intensité du courant circulant dans un conducteur électrique respectif et un premier moyen de détection propre à détecter une perte de tension en aval du disjoncteur, la perte de tension en aval du disjoncteur correspondant à une ouverture du disjoncteur ou à une chute de tension en entrée du disjoncteur en dessous d'une première valeur de tension de référence. Conformément à l'invention, l'appareil auxiliaire comprend un dispositif de détermination d'une cause de la perte de tension en aval du disjoncteur, en fonction de l'intensité mesurée par le ou chaque capteur de courant, ladite cause étant de préférence choisie parmi le groupe consistant en : une surcharge électrique, un court-circuit, et une chute de tension.

Suivant d'autres aspects avantageux de l'invention, l'appareil auxiliaire comprend une ou plusieurs des caractéristiques suivantes, prises isolément ou suivant toutes les combinaisons techniquement admissibles :
- le disjoncteur comporte une borne d'entrée du courant et une borne de sortie du courant pour chaque conducteur électrique, alors que le premier moyen de détection comprend au moins un capteur de tension propre à mesurer la tension délivrée à une borne de sortie respective du disjoncteur, et alors que le premier moyen de détection est propre à détecter la perte de tension en aval du disjoncteur si la tension mesurée par le capteur de tension est inférieure à une deuxième valeur de tension de référence pendant un intervalle de temps prédéterminé ;
- le disjoncteur comporte une borne d'entrée du courant et une borne de sortie du courant pour chaque conducteur électrique, alors que le premier moyen de détection comprend au moins un capteur de tension propre à mesurer la tension délivrée à une borne de sortie respective du disjoncteur, et alors que le premier moyen de détection est propre à calculer une dérivée de la tension mesurée et à détecter la perte de tension en aval du disjoncteur si la dérivée calculée par le premier moyen de détection est inférieure à une valeur de référence pendant un temps de référence prédéterminé.
- le disjoncteur comprend au moins un deuxième moyen de détection propre à détecter une surcharge électrique, tandis que l'appareil auxiliaire comprend un premier moyen de calcul propre à calculer un échauffement du ou de chaque deuxième moyen de détection, en fonction de l'intensité mesurée par le ou chaque capteur de courant, le dispositif de détermination étant propre à déterminer la cause de la perte de tension en aval du disjoncteur en fonction dudit échauffement calculé ;

- l'appareil auxiliaire comprend un deuxième moyen de calcul propre à calculer une valeur maximale des intensités mesurées pendant un laps de temps prédéterminé, le dispositif de détermination étant propre à déterminer la cause de la perte de tension en aval du disjoncteur en fonction de la valeur maximale des intensités mesurées ;
- l'appareil auxiliaire comprend un troisième moyen de calcul propre à calculer une puissance électrique et une énergie électrique traversant chaque conducteur correspondant à partir des valeurs d'intensité et de tension mesurées par respectivement le ou chaque capteur de courant et le ou chaque capteur de tension, alors que l'appareil auxiliaire comprend un organe de communication propre à transmettre les valeurs d'intensité et de tension mesurées et les valeurs d'énergie et de puissance calculées vers un concentrateur.

L'invention a également pour objet un système électrique comprenant un disjoncteur électrique et un appareil auxiliaire couplé électriquement au disjoncteur électrique, le disjoncteur électrique étant, en position ouverte, propre à interrompre la circulation d'un courant électrique dans une liaison électrique comportant au moins un conducteur électrique. Conformément à l'invention, l'appareil auxiliaire est conforme à l'appareil auxiliaire présenté ci-dessus.

L'invention sera mieux comprise et d'autres avantages de celle-ci apparaitront plus clairement à la lumière de la description qui va suivre, donnée uniquement à titre d'exemple non limitatif, et faite en se référant aux dessins annexés sur lesquels :
- la figure 1 est une représentation schématique d'un système électrique selon un premier mode de réalisation de l'invention comprenant un disjoncteur électrique et un appareil auxiliaire couplé électriquement audit disjoncteur ;
- la figure 2 est une représentation très schématique de l'appareil auxiliaire de la figure 1 ;
- la figure 3 est un organigramme d'un procédé de détermination d'une cause de perte de tension en aval du disjoncteur de la figure 1 conforme à l'invention ;
- la figure 4 est un ensemble de deux courbes représentant l'échauffement calculée par l'appareil auxiliaire, en fonction du temps, pour deux valeurs différentes de l'intensité d'un courant traversant un conducteur électrique auquel est connecté le disjoncteur de la figure 1 ;
- la figure 5 est un ensemble de deux courbes représentant, lors de l'ouverture du disjoncteur de la figure 1, d'une part, un courant traversant un conducteur électrique auquel est connecté le disjoncteur, en fonction du temps, et d'autre part, une tension mesurée en sortie du disjoncteur sur un conducteur électrique, en fonction du temps ;
- la figure 6 est un ensemble de trois courbes représentant, en fonction du temps et au moment de la perte de tension en aval du disjoncteur de la figure 1, la tension mesurée en trois points différents de mesure au sein de l'appareil auxiliaire de la figure 2 ; et
- la figure 7 est une représentation schématique d'un système électrique selon un deuxième mode de réalisation de l'invention, comprenant un disjoncteur électrique tétrapolaire et un appareil auxiliaire couplé électriquement audit disjoncteur.

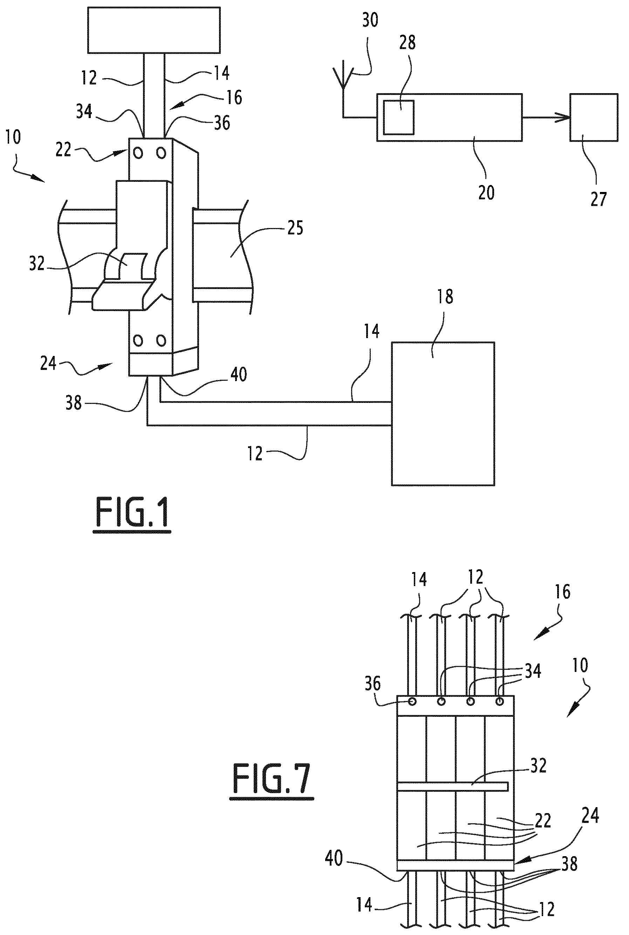

Sur la figure 1, un système électrique 10 est connecté à un premier conducteur électrique 12 et à un deuxième conducteur électrique 14, les conducteurs 12, 14 appartenant à un réseau de distribution électrique 16 et étant destinés à alimenter une charge électrique 18.

Le système électrique 10 est propre à communiquer via une liaison sans fil avec un concentrateur 20 de données.

Le système électrique 10 comprend un disjoncteur électrique 22, tel qu'un disjoncteur électromécanique, de préférence un disjoncteur magnétothermique, et un appareil auxiliaire 24 couplé électriquement au disjoncteur 22. L'appareil auxiliaire 24 est, par exemple, fixé sous le disjoncteur 22.

Le système électrique 10 comprend un rail 25 sur lequel est fixé mécaniquement le disjoncteur 22.

Le premier conducteur 12 est par exemple un conducteur de phase ou un encore un conducteur de potentiel continu positif.

Le deuxième conducteur 14 est par exemple un conducteur de neutre ou encore un conducteur de potentiel continu de référence.

Le premier conducteur 12 et le deuxième conducteur 14 forment une liaison électrique 16.

Le concentrateur de données 20 est relié, via une liaison de données, telle qu'une liaison radioélectrique, à un dispositif de visualisation 27, afin d'afficher notamment des informations relatives au fonctionnement du disjoncteur 22 transmises par l'appareil auxiliaire 24. Le concentrateur 20 comprend un premier organe de communication 28 et une première antenne radioélectrique 30.

Le disjoncteur électrique 22 est connu en soi, et est propre à interrompre la circulation d'un courant électrique traversant le premier conducteur 12 et/ou le deuxième conducteur 14 notamment en présence d'un défaut électrique sur le premier conducteur 12 ou le deuxième conducteur 14.

Le disjoncteur 22 comporte un organe mécanique de sortie 32, visible sur la figure 1, l'organe mécanique de sortie 32 étant mobile entre une position d'opération et une position d'arrêt correspondant à l'interruption de la circulation du courant dans les conducteurs 12 et 14, après une ouverture du disjoncteur 22. L'organe mécanique de sortie 32 est monté mobile vers la position d'arrêt en cas de surcharge sur le premier ou deuxième conducteurs 12, 14 ou d'ouverture manuelle du disjoncteur électrique 22.

Le disjoncteur 22 comprend au moins un moyen de détection, non représenté, tel qu'un bilame, propre à détecter une surcharge électrique sur le premier conducteur 12 ou sur le deuxième conducteur 14, et également appelé moyen de détection d'une surcharge.

Le disjoncteur électrique 22 est, par exemple, un disjoncteur magnétothermique propre à interrompre la circulation du courant dans les premier et/ou deuxième conducteurs 12, 14, par effet thermique, dans le cas d'une surcharge, et par effet magnétique, dans le cas d'un court-circuit.

Le disjoncteur 22 comporte une première 34 et une deuxième 36 bornes d'entrée du courant et une première 38 et une deuxième 40 borne de sortie du courant, les premières bornes d'entrée et de sortie 34, 38 étant associées au premier conducteur électrique 12 et les deuxièmes bornes d'entrée et de sortie 36, 40 étant associées au deuxième conducteur électrique 14.

Le disjoncteur 22 est en position ouverte propre à interrompre la circulation d'un courant électrique I à travers la liaison électrique 16. Plus généralement, la perte de tension en aval du disjoncteur 22 survient, lorsqu'il est en position ouverte ou suite à une chute de tension en entrée du disjoncteur 22 en dessous d'une première valeur de tension de référence. La première valeur de tension de référence est par exemple comprise entre 0 Volts et 50 Volts. La présence de tension en aval du disjoncteur 22 résulte de la position fermée du disjoncteur, c'est-à-dire que ledit disjoncteur est propre à laisser circuler un courant à travers la liaison électrique 16, et que la tension en entrée du disjoncteur est supérieure à la première tension de référence.

L'appareil auxiliaire 24 comprend un capteur de courant 44, un capteur de tension 46, une unité de traitement 48, un organe d'alimentation électrique 50, un régulateur de tension 51, un organe 52 de stockage d'énergie électrique, un deuxième organe de communication 53 et une deuxième antenne radioélectrique 54.

En complément, dans le cas d'un courant alternatif, l'appareil auxiliaire 24 comprend un capteur de courant différentiel, non représenté, propre à mesurer un courant différentiel entre le premier conducteur 12 et le deuxième conducteur 14.

Le dispositif de visualisation 27 comporte notamment un écran d'affichage, non représenté, et des moyens, non représentés, d'affichage à l'écran de données reçues du concentrateur de données 20.

Le premier organe de communication 28 est apte à transmettre des données vers l'appareil auxiliaire 24 via la première antenne 30 et à établir une liaison radioélectrique avec l'appareil auxiliaire 24.

L'organe mécanique de sortie 32 est connu en soi, et est également appelé manette 32 de réarmement du disjoncteur 22.

La manette de réarmement 32 est mobile entre sa position d'opération correspondant à l'état fermé du disjoncteur 22 et sa position d'arrêt correspondant à l'état ouvert du disjoncteur 22 en cas d'actionnement manuel de la manette 32, ou encore à l'état déclenché du disjoncteur 22 en cas de surcharge ou de court-circuit dans le premier 12 et/ou le deuxième 14 conducteurs.

La manette de réarmement 32 permet de réarmer le disjoncteur 22 après un déclenchement, c'est-à-dire de faire passer le disjoncteur 22 de son état ouvert ou déclenché à son état fermé, afin de laisser à nouveau le courant circuler dans les premier 12 et deuxième 14 conducteurs. La manette 32 permet également d'ouvrir manuellement le disjoncteur 22.

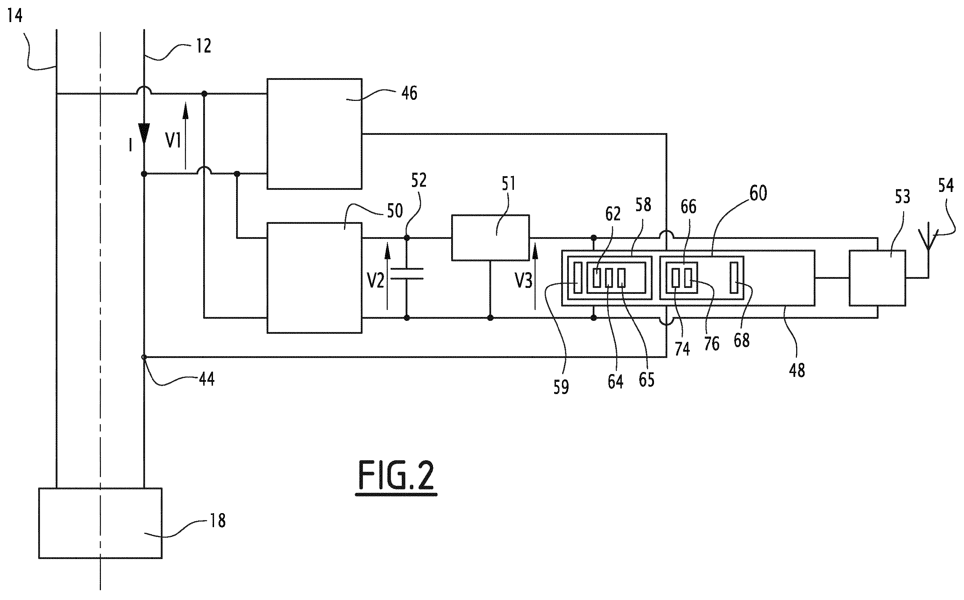

Le capteur de courant 44, visible sur la figure 2, est connu en soi, et est propre à mesurer l'intensité d'un courant I circulant dans le premier conducteur électrique 12. Le capteur de courant 44 est par exemple un capteur de courant de phase, et comporte alors, par exemple, un tore de Rogowski, un shunt ou encore un capteur à effet Hall. Dans la suite de la description, le courant et l'intensité du courant portent la même référence I.

En complément, l'appareil auxiliaire 24 comprend un deuxième capteur de courant, non représenté, propre à mesurer l'intensité d'un courant circulant dans le deuxième conducteur électrique 14.

Le capteur de tension 46 est connu en soi, et est propre à mesurer une première tension V1 délivrée entre la première borne de sortie 38 et la deuxième borne de sortie 40. Le capteur de tension 46 permet plus précisément de mesurer la première tension V1 en sortie du disjoncteur 22, au niveau du premier conducteur électrique 12.

L'unité de traitement 48 comporte un processeur 58, un moyen de détection 59 propre à détecter la perte de tension en aval du disjoncteur 22, et également appelé moyen de détection 59 de la perte de tension en aval du disjoncteur 22, et une mémoire 60 associée au processeur 58, comme représenté sur la figure 2.

Le moyen de détection 59 de la perte de tension en aval du disjoncteur 22 et le moyen de détection d'une surcharge sont respectivement appelés par la suite premier moyen de détection 59 et deuxième moyen de détection.

L'organe d'alimentation électrique 50 est propre à récupérer une partie de l'énergie électrique transmise sur les conducteurs électriques 12, 14 et à alimenter en énergie électrique l'appareil auxiliaire 24.

Le régulateur de tension 51 permet d'adapter la tension délivrée par l'alimentation électrique 50 à une valeur de tension acceptable par l'unité de traitement 48 et l'organe de communication 53. Le régulateur 51 est par exemple un convertisseur continu-continu qui délivre une tension continue de 3,3V.

L'organe de stockage 52 d'énergie électrique est propre à emmagasiner une partie de l'énergie électrique délivrée par l'alimentation électrique 50 lorsque le disjoncteur 22 est fermé, et à restituer l'énergie électrique stockée après la perte de tension en aval du disjoncteur 22.

Sur la figure 2, l'organe de stockage 52 est un condensateur dont la valeur de capacité est fonction, entre autres, de la consommation électrique moyenne de l'appareil auxiliaire 24 et de la tension d'alimentation à délivrer au deuxième organe de communication 53 et à l'unité de traitement 48.

Le deuxième organe de communication 53 est apte à recevoir des données en provenance du concentrateur de données 20, et plus précisément en provenance du premier organe de communication 28 et de la première antenne 30, et à établir une liaison radioélectrique avec le concentrateur 20. Le deuxième organe de communication 53 est propre à générer un message M1 comprenant des données issues de l'unité de traitement 48, puis à émettre, via la deuxième antenne 54, le message M1 à destination du concentrateur de données 20.

Avantageusement, les organes de communication 28, 53 et les antennes 30, 54 sont conformes au protocole de communication ZIGBEE ou ZIGBEE GREEN POWER, basé sur la norme IEEE-802.15.4.

En variante, l'organe de communication 53 est propre à communiquer avec le concentrateur de données 20 via une liaison filaire, non représentée.

La deuxième antenne radioélectrique 54 est propre à transmettre et à recevoir des informations vers et en provenance de la première antenne radioélectrique 30.

Le processeur 58 comprend un premier logiciel 62 de calcul d'un échauffement θ du deuxième moyen de détection, en fonction de l'intensité du courant I mesurée par le capteur de courant 44. Le processeur 58 comprend également un deuxième logiciel 64 de calcul d'une valeur maximale Iₘₐₓ des intensités mesurées, également appelé intensité maximale Iₘₐₓ, pendant un laps de temps T1 prédéterminé.

Le processeur 58 comprend un premier logiciel 65 de comparaison de l'échauffement θ avec une première valeur de seuil S1.

En complément, le premier logiciel de comparaison 65 est propre à comparer l'échauffement θ avec, d'une part, la première valeur de seuil S1, et d'autre part, une deuxième valeur de seuil S2 inférieure à la première valeur de seuil S1. La première valeur de seuil S1 est paramétrée afin de correspondre à l'échauffement θ du deuxième moyen de détection lorsqu'il est traversé par un courant compris entre 60% et 90% du courant nominal du disjoncteur 22, tandis que la deuxième valeur de seuil S2 est comprise entre 80% et 95% de la première valeur de seuil S1.

Le premier moyen de détection 59 est propre à détecter la perte de tension en aval du disjoncteur 22 si la première tension V1, mesurée par le capteur de tension 46, est inférieure à une deuxième valeur de tension de référence Vref pendant un intervalle de temps T2 prédéterminé. La deuxième valeur de tension de référence Vref est par exemple inférieure à 20% de la tension nominale du réseau 16.

En variante, le premier moyen de détection 59 est propre à mesurer l'ondulation de la tension mesurée par le capteur de tension 46. Afin de mesurer l'ondulation, le premier moyen de détection 59 est apte à calculer une dérivée de la tension mesurée. Ainsi, si la dérivée, exprimée en volts par millisecondes (V/ms), calculée par le premier moyen de détection 59 est inférieure à une valeur de référence, par exemple comprise entre 1% et 10% de la tension nominale des disjoncteurs 22, soit entre 2,3 V/ms et 23V/ms pour une tension nominale de 230V, pendant un temps de référence T3 prédéterminé, le premier moyen de détection est propre à détecter la perte de tension en aval du disjoncteur 22. Le temps de référence T3 est de préférence compris entre 5 ms et 20 ms.

La mémoire 60 est apte à stocker une application 66 de détermination de la cause de la perte de tension en aval du disjoncteur détectée en fonction de l'intensité mesurée par le capteur de courant 44. La mémoire 60 est également apte à stocker un logiciel 68 d'échantillonnage de l'intensité du courant I mesurée par le capteur de courant 44, et de la première tension V1 mesurée par le capteur de tension 46. La mémoire 60 est également apte à stocker des échantillons de l'intensité du courant I mesurée par le capteur de courant 44 et aussi de la première tension V1 mesurée par le capteur de tension 46, ainsi que des valeurs de puissance et d'énergie électriques calculées via le processeur 58 à partir des valeurs d'intensité I et de première tension V1 mesurées.

L'application de détermination 66 est propre à déterminer la cause de la perte de tension en aval du disjoncteur détectée par le premier moyen de détection 59 en fonction de l'intensité du courant I mesurée par le capteur de courant 44. L'application de détermination 66 comprend un deuxième logiciel 74 de comparaison de l'échauffement θ calculé avec une troisième valeur de seuil S3 et un troisième logiciel 76 de comparaison de la valeur maximale Iₘₐₓ des intensités mesurées avec une quatrième valeur de seuil S4. La troisième valeur de seuil S3 est fixée à une valeur d'échauffement θ correspondant à un courant compris entre 100% et 120% du courant nominal du disjoncteur 22, tandis que la quatrième valeur de seuil S4 est comprise entre 3 et 10 fois le courant nominal du disjoncteur 22.

En variante, l'application de détermination 66 comprend également un troisième logiciel, non représenté, de calcul d'une durée pendant laquelle l'échauffement θ calculé est supérieur à la troisième valeur de seuil S3. Dans cette variante, l'application de détermination 66 comprend un quatrième logiciel de comparaison, non représenté. Le quatrième logiciel de comparaison est propre à comparer la durée calculée par le troisième logiciel de calcul avec une durée de référence.

En complément, l'application de détermination 66 comporte un logiciel, non représenté, de datation, du ou des dépassements des troisième S3 et quatrième S4 valeurs de seuil par respectivement l'échauffement θ et la valeur maximale Iₘₐₓ des intensités mesurées.

Le deuxième logiciel de comparaison 74 est apte à comparer l'échauffement θ avec une troisième valeur de seuil S3 afin de déterminer une première cause de la perte de tension en aval du disjoncteur 22. Plus précisément, la première cause de la perte de tension en aval du disjoncteur 22 correspond à une surcharge électrique, et est détectée si l'échauffement θ est supérieur à la troisième valeur de seuil S3

Le troisième logiciel de comparaison 76 est apte à comparer l'intensité maximale Iₘₐₓ calculée avec la quatrième valeur de seuil S4 afin de déterminer une deuxième cause de la perte de tension en aval du disjoncteur 22, distincte de la première cause de la perte de tension en aval. Plus précisément, la deuxième cause de perte de tension en aval du disjoncteur 22, correspond à la présence d'un courant de court-circuit sur le premier conducteur 12, et est détectée si l'intensité maximale Iₘₐₓ est supérieure à la quatrième valeur de seuil S4.

Si après la perte de tension en aval du disjoncteur 22, les troisième S3 et quatrième S4 valeurs de seuil ne sont pas dépassés par respectivement l'échauffement θ et l'intensité maximale Iₘₐₓ, alors une troisième cause de la perte de tension en aval du disjoncteur, distincte des première et deuxième causes est détectée. La troisième cause est une chute de tension et correspond à une ouverture manuelle du disjoncteur 22 ou à une chute ou coupure de la tension arrivant sur les bornes d'entrée 34, 36.

La troisième valeur de seuil S3 est supérieure à la première valeur de seuil S1 et à la deuxième valeur de seuil S2. La première valeur de seuil S1 est supérieure à la deuxième valeur de seuil S2.

Le message M1 comprend une première donnée STATUT correspondant à l'état du disjoncteur 22, c'est-à-dire à l'absence ou perte de tension en aval du disjoncteur 22 ou à l'état fermé sous tension du disjoncteur, et une deuxième donnée DEFAUT correspondant à la cause de la perte de tension en aval du disjoncteur. La cause de la perte de tension en aval du disjoncteur 22 est de préférence choisie parmi le groupe consistant en : une surcharge électrique, un court-circuit, et une chute de tension.

La première donnée STATUT est propre à prendre deux valeurs différentes, une première valeur ON et une deuxième valeur OFF. La première valeur ON correspondant, dans le cas présent, à la position fermée sous tension du disjoncteur 22 et la deuxième valeur OFF à la perte de tension en aval du disjoncteur 22.

Lorsque la cause de la perte de tension en aval du disjoncteur 22 déterminée est une chute de tension, la cause de la perte de tension en aval correspond en fait à une ouverture manuelle, ou bien à une coupure ou une chute de la tension arrivant sur les bornes d'entrée 34, 36, à une valeur inférieure à la première valeur de tension de référence.

En complément, le message M1 comprend les valeurs d'intensité du courant I et de la première tension V1 mesurées et calculées, ainsi que les valeurs d'énergie et de puissance associées.

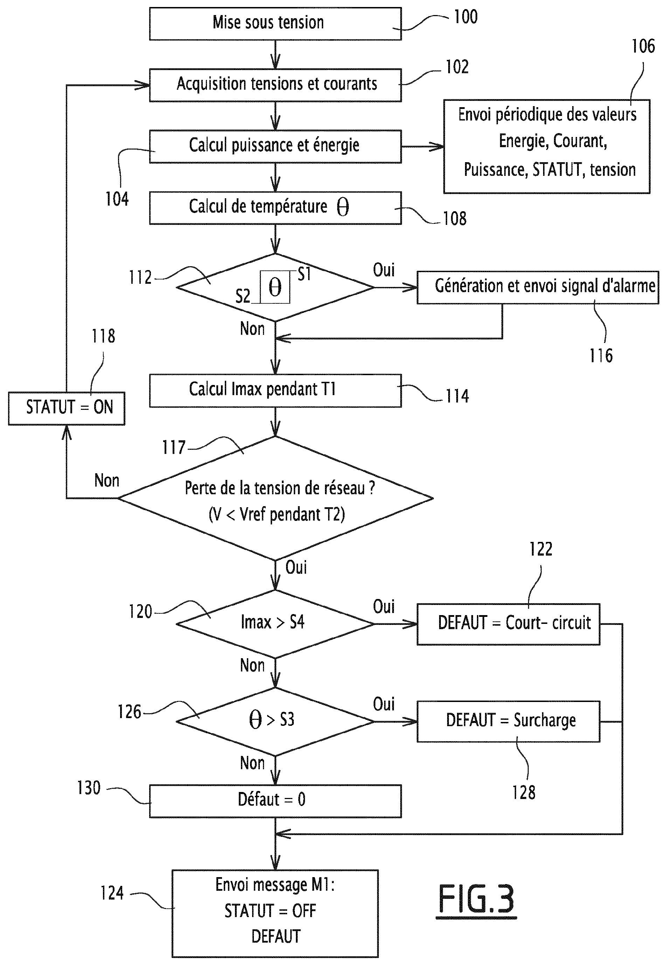

Le fonctionnement du système électrique 10 selon l'invention va désormais être expliqué à l'aide de la figure 3.

Dans l'exemple considéré l'appareil auxiliaire 24 comprend un seul capteur de courant 44 autour du premier conducteur 12. Ainsi, dans le procédé présenté ci-dessous, la cause de la perte de tension en aval du disjoncteur 22 est fonction du courant traversant le premier conducteur 12 et le courant traversant le deuxième conducteur 14 n'est pas considéré. En variante, et comme cela sera décrit par la suite, un capteur de courant supplémentaire est positionné autour du deuxième conducteur 14.

Lors d'une étape initiale 100, le système électrique 10 est connecté sur les premier 12 et deuxième 14 conducteurs électriques qui sont mis sous tension, c'est-à-dire traversés par un courant afin d'alimenter la charge électrique 18.

Puis, lors d'une étape suivante 102, l'intensité du courant I et la première tension V1 sont régulièrement mesurées par les capteurs de courant 44 et de tension 46.

Au cours d'une étape 104 suivante, l'appareil auxiliaire 24, via le processeur 58, calcule l'énergie électrique et la puissance qui traversent le disjoncteur 22 à partir des valeurs de courant I et de première tension V1 mesurées à l'étape 102. Lors d'une étape 106, le deuxième organe de communication 53 envoie périodiquement un deuxième message M2 avec une période P prédéterminée. Le deuxième message M2 comprend les valeurs de courant I et de première tension V1 mesurées, ainsi que l'énergie et la puissance électrique calculées et la première donnée STATUT correspondant soit à la perte de tension en aval du disjoncteur 22, soit à l'état fermé sous tension du disjoncteur 22. Ensuite, lors d'une étape 108, le premier logiciel de calcul 62, calcule l'échauffement θ à partir des valeurs des intensités du courant I mesurées.

Au cours de l'étape 108, afin de calculer l'échauffement θ, le premier logiciel de calcul 62 calcule le carré de la valeur de l'intensité du courant I mesurée. Puis, le carré de la valeur de l'intensité du courant I est filtrée à l'aide d'un filtre passe-bas de type RC. Le premier logiciel de calcul 62, applique l'équation suivante de filtrage suivant un indice N d'échantillon du courant I mesuré : θ_{N} = θ_{N-1} x A + I_{N} x I_{N} x B avec : A+B =1 et A et B des coefficients de valeur comprise entre 0 et 1. La dernière valeur θ_{N} de l'échauffement θ calculé est ensuite utilisée pour les étapes qui font suite à l'étape de calcul 108.

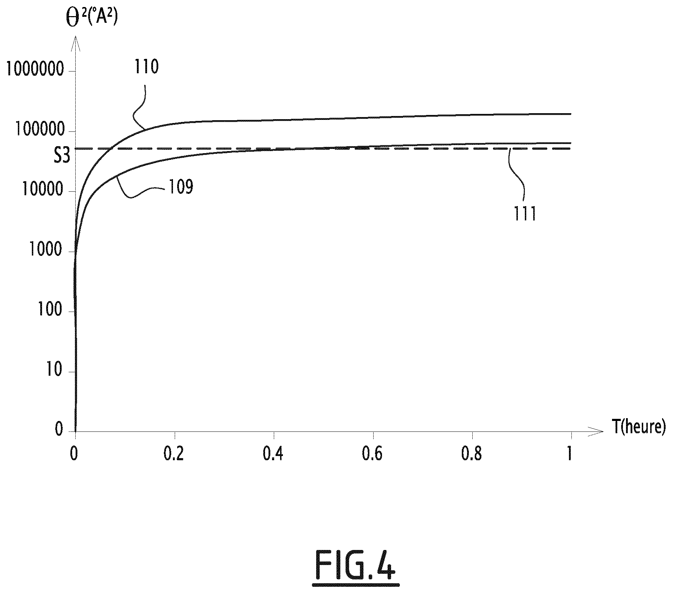

Le choix des coefficients A et B dépend d'une fréquence d'échantillonnage du courant I mesuré par le capteur de courant 44, et d'une constante de temps correspondant à un temps écoulé. Le temps écoulé est le temps nécessaire pour qu'une intensité prédéterminée du courant I traverse le conducteur électrique 12, avant que le premier moyen de détection 59 détecte une surcharge et déclenche l'ouverture du disjoncteur 22. L'échauffement θ ainsi calculé permet de modéliser la courbe de déclenchement thermique du disjoncteur 22. Il est possible de régler les valeurs de A et B pour que la courbe de déclenchement simulée corresponde à la constante de temps présentée ci-dessus. Les coefficients A et B dépendent également des caractéristiques physiques du deuxième moyen de détection. A la figure 4, une première courbe 109 représente l'évolution de l'échauffement θ, en fonction du temps, pour un courant mesuré par le capteur de courant 44 dont la valeur est égale à 1,3 fois une valeur nominale In du courant propre à traverser le disjoncteur 22. Une deuxième courbe 110 représente l'évolution de l'échauffement θ, en fonction du temps, pour un courant mesuré par le capteur de courant 44 dont la valeur est égale 2 fois la valeur nominale du courant In. On observe ainsi que plus le courant mesuré est élevé, plus la valeur de l'échauffement θ augmente rapidement, et plus vite elle dépasse la troisième valeur de seuil S3 représentée par une ligne horizontale 111.

Au cours d'une étape 112, le premier logiciel de comparaison 65 compare l'échauffement θ calculé avec la première valeur de seuil S1.

Si l'échauffement θ calculé est inférieur à la première valeur de seuil S1, alors, le deuxième logiciel de calcul 64 calcule, lors d'une étape 114, la valeur maximale Iₘₐₓ de l'intensité mesurée pendant le laps de temps T1, c'est-à-dire à partir des valeurs de courant I mesurées pendant le laps de temps T1 précédemment à l'étape 114 de calcul. Le laps de temps T1 est de préférence compris entre 60 millisecondes (ms) et 160 ms.

Si l'échauffement θ calculé est supérieur à la première valeur de seuil S1, alors l'unité de traitement 48 réalise une étape 116 au cours de laquelle elle génère un signal d'alarme qu'elle transmet au deuxième organe de communication 53, qui transmet par la suite le signal d'alarme au concentrateur 20.

En complément, et comme représenté à la figure 3 par l'utilisation du symbole suivant : 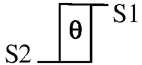 , lors de l'étape 112, le premier logiciel de comparaison 65 compare également l'échauffement θ calculé avec la deuxième valeur de seuil S2. Le signal d'alarme est généré et envoyé à partir du moment où l'échauffement θ est supérieur à la première valeur de seuil S1 et tant que la valeur de l'échauffement θ est supérieure à la deuxième valeur de seuil S2. On a ainsi un fonctionnement en hystérésis au cours de l'étape 112 avec la deuxième valeur de seuil S2 de préférence comprise entre 80% et 95% de la première valeur de seuil S1. Puis, suite à l'étape 116, l'unité de traitement 48 effectue l'étape 114.

En variante, les étapes 112 et 116 sont réalisées parallèlement au procédé de détermination de la cause de la perte de tension en aval du disjoncteur 22. Plus précisément, dans cette variante, suite à l'étape 108 on passe directement à l'étape 114, et les étapes 112 et 116 sont réalisées de manière répétitive, suivant une période de répétition prédéterminée.

Ensuite, au cours d'une étape 117, le premier moyen de détection 59 détecte la perte de la tension en aval du disjoncteur électrique 22 à partir des valeurs de première tension V1 mesurées par le capteur de tension 46. Plus précisément, le premier moyen de détection 59 détecte la perte de tension en aval du disjoncteur si la première tension V1 mesurée par le capteur de tension 46 est inférieure à la deuxième valeur de tension de référence Vref pendant l'intervalle de temps T2. L'intervalle de temps T2 est de préférence compris entre 5 ms et 10 ms.

En variante non représenté, lors de l'étape 117, le premier moyen de détection 59 détecte la perte de la tension en aval du disjoncteur électrique 22 en mesurant l'ondulation de la tension mesurée par le capteur de tension 46. Afin de mesurer l'ondulation, le premier moyen de détection 59 calcule une dérivée de la tension mesurée, et si la dérivée calculée par le premier moyen de détection 59 est inférieure à la valeur de référence, par exemple comprise entre 1% et 10% de la tension nominale des disjoncteurs 22, pendant le temps de référence T3 prédéterminé, le premier moyen de détection 59 détecte la perte de tension en aval du disjoncteur 22.

Si le premier moyen de détection 59 détecte que le disjoncteur 22 est en position fermé sous tension, alors, la première donnée STATUT prend, lors d'une étape 118, la première valeur ON, et l'unité de traitement 48 revient à l'étape 102.

Si le premier moyen de détection 59 détecte la perte de tension en aval du disjoncteur 22, alors l'unité de traitement 48 réalise une étape 120 suivante au cours de laquelle le troisième logiciel de comparaison 76 compare l'intensité maximale Iₘₐₓ calculée, au cours de l'étape 112, avec la quatrième valeur de seuil S4 afin de détecter la deuxième cause de la perte de tension en aval du disjoncteur 22.

Si l'intensité maximale Iₘₐₓ calculée est supérieure à la quatrième valeur de seuil S4, alors au cours d'une étape 122 l'unité de traitement 48 fixe la deuxième donnée DEFAUT à la valeur court-circuit. La cause de la perte de tension en aval du disjoncteur 22 détectée est alors la présence d'un courant de court-circuit au niveau du premier conducteur 12. Suite à l'étape 122, l'unité de traitement 48 réalise une étape 124 au cours de laquelle le deuxième organe de communication 53 transmet au concentrateur 20 au moins la première donnée STATUT et la deuxième donnée DEFAUT, afin qu'un opérateur soit apte à identifier à partir du dispositif de visualisation 27 la cause de la perte de tension en aval du disjoncteur 22.

Si l'intensité maximale Iₘₐₓ calculée est inférieure à la quatrième valeur de seuil S4, au cours de l'étape 120, alors, lors d'une étape 126 le deuxième logiciel de comparaison 74 compare l'échauffement θ calculé à l'étape 108 avec la troisième valeur de seuil S3, afin de détecter la première cause de la perte de tension en aval du disjoncteur 22. Si l'échauffement θ calculé est supérieur à la troisième valeur de seuil S3, alors l'unité de traitement 48 fixe, au cours d'une étape 128, la deuxième donnée DEFAUT à la valeur surcharge, et le défaut identifié ayant causé la perte de tension en aval du disjoncteur est une surcharge électrique sur le premier conducteur 12. Suite à l'étape 128, l'unité de traitement 48 réalise via l'organe de communication l'étape 124.

Dans le cas où la dernière valeur d'échauffement θ calculé est inférieure à la troisième valeur de seuil S3, alors l'unité de traitement 48 réalise une étape 130 au cours de laquelle elle fixe la deuxième donnée DEFAUT à la valeur 0, ce qui correspond à une ouverture manuelle du deuxième organe mécanique 32 ou à une coupure de la tension arrivant sur les première et deuxième bornes d'entrée 34, 36.

Puis, suite à l'étape 130, l'unité de traitement 48 réalise l'étape 124.

En complément, dans le cas d'une installation électrique équipée d'une pluralité de systèmes électriques 10 et donc d'une pluralité d'appareils auxiliaires 24, chaque appareil auxiliaire 24 procède à l'étape 124 en trois instants aléatoires distincts afin d'augmenter les chances de réception des premiers messages M1 envoyés vers le concentrateur 20.

L'intervalle de temps T2 est de préférence compris entre 5 ms et 10 ms, afin que l'unité de traitement 48 ait assez de temps pour la détection du court-circuit et pour la transmission du message M1 réalisée à l'étape 124. En outre, le fait d'avoir un intervalle de temps T2 court permet de détecter les micro-coupures du réseau 16 et ainsi de mesurer la qualité de la tension fournie par un distributeur d'énergie électrique qui gère le réseau 16.

Grâce à l'invention, un opérateur connait la cause de la perte de tension en aval du disjoncteur et décide des actions de réparation à effectuer en fonction de cette cause.

Le signal d'alarme permet d'informer un opérateur que la charge électrique 18 est élevée, par exemple de l'ordre de 80% d'une charge maximale acceptable par le disjoncteur 22, et que si la charge est augmentée, le disjoncteur 22 risque de passer en position ouverte. En outre, le fait d'utiliser deux valeurs distinctes de seuil S1, S2, permet d'éviter des passages intempestifs entre l'émission d'un signal d'alarme et l'arrêt de cette émission, et inversement.

Lorsque le capteur de courant 44 est un capteur linéaire, tel qu'un tore de Rogowski, un shunt, ou tout autre moyen, la dynamique de mesure est meilleure, ce qui permet d'améliorer la détermination de la cause du déclenchement détecté.

De plus, l'appareil auxiliaire 24 selon l'invention se couple électriquement et mécaniquement au disjoncteur 22 sans modification de celui-ci. Il est ainsi plus facile d'installer l'appareil auxiliaire 24 sur des disjoncteurs existants.

Le laps de temps T1, pendant lequel l'intensité maximale Iₘₐₓ est calculée, est compris entre 60 ms et 160 ms de manière à ce que, dans le cas où la charge électrique 18 est un moteur maintenant une tension contre-électromotrice après une ouverture du disjoncteur 22 entraînant une coupure de la tension sur les conducteurs 12, 14, le laps de temps T1 soit assez long pour que le pic du courant I mesuré, dû au court-circuit, soit détecté.

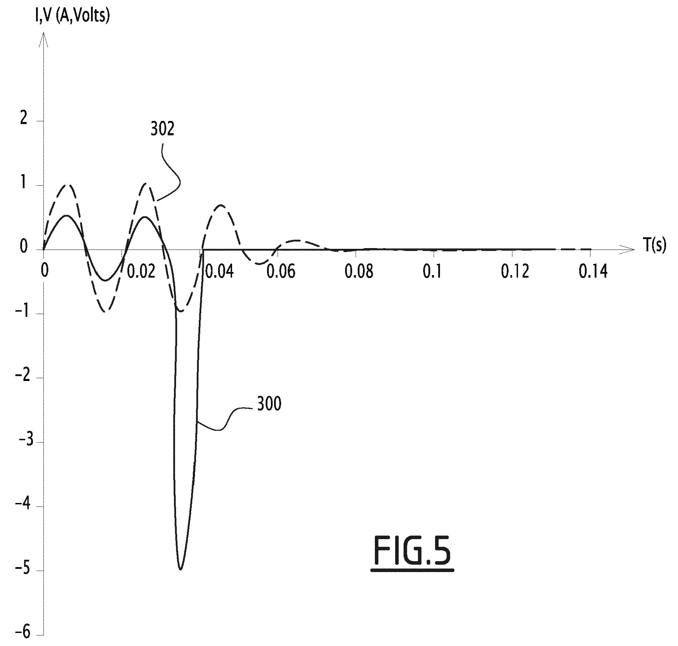

A la figure 5, on observe une troisième courbe 300 correspondant au courant traversant le disjoncteur 22, en fonction du temps et une quatrième courbe 302 représentant la tension entre les bornes de sortie 38, 40 du disjoncteur 22. Sur la courbe 300, on observe un pic d'intensité correspondant à un court-circuit.

Lorsque le courant I a une intensité nulle, alors le disjoncteur 22 est ouvert. Cependant, il apparait sur la courbe 302 que lorsque le disjoncteur 22 est ouvert et que le courant est nul, c'est-à-dire pour un temps de 0,04 secondes (s), la tension n'est pas nulle et diminue progressivement après l'ouverture du disjoncteur 22. La tension mesurée n'est pas nulle à cause de la force contre-électromotrice générée par la charge 18 de type moteur. Ainsi, lors de la coupure réalisée par le disjoncteur 22, la première tension V1 mesurée entre les bornes de sortie 38, 40 ne disparait pas instantanément. La première tension V1 est maintenue à une valeur non nulle par la tension contre-électromotrice de la charge 18 de type moteur pendant un certain temps de l'ordre de 60 ms. Le premier moyen de détection 59 détecte donc l'ouverture du disjoncteur 22 à un temps supérieur à 0,04 s. Il est donc nécessaire afin de calculer la valeur d'intensité maximale Iₘₐₓ, après l'ouverture du disjoncteur 22, de calculer l'intensité maximale Iₘₐₓ pendant un temps compris entre 60 millisecondes et 160 millisecondes de manière à bien détecter le pic de courant correspondant à l'intensité maximale qui apparaît lors d'un court-circuit. Si le laps de temps T1 a une valeur trop petite, alors, lorsqu'au cours de l'étape 117, la perte de la tension du réseau sera détectée, la valeur Iₘₐₓ calculée à l'étape 112 ne correspondra pas au courant de court-circuit.

Par ailleurs, au cours de l'étape 117, la valeur de la première tension V1 considérée afin de réaliser la comparaison est mesurée entre le premier conducteur 12 et le deuxième conducteur 14. Ceci permet une détection quasi-immédiate de la chute de tension et donc de la perte de tension en aval du disjoncteur 22. L'intervalle de temps T2 est donc compris entre 5 ms et 10 ms afin d'avoir un compromis optimal entre la rapidité de la détection de la chute de tension en aval du disjoncteur 22 et une distinction avec les micro-coupures de la tension délivrée par le réseau 16.

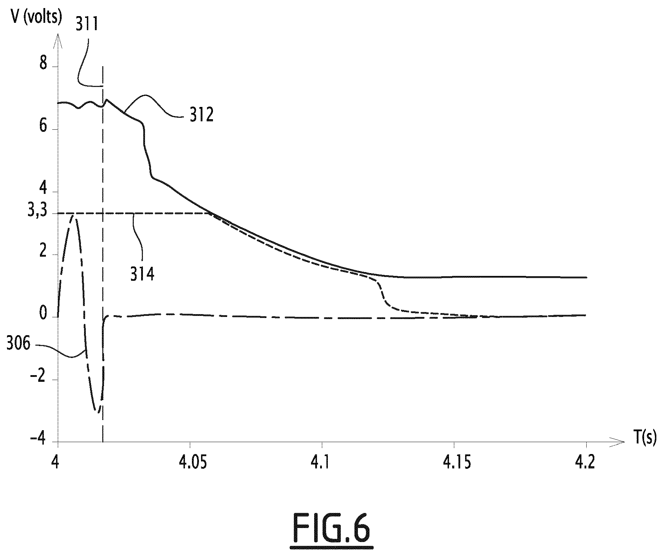

La forme de la première tension V1 est représentée à la figure 6 par une cinquième courbe 306 en trait discontinu. La première tension V1 prend la valeur zéro dès l'ouverture du disjoncteur 22, représentée par une première ligne verticale 311, représentée en traits pointillés.

En variante, afin de réaliser l'étape 117, on compare la deuxième tension de référence avec une deuxième tension V2 mesurée aux bornes de l'organe de stockage 52 comme présenté à la figure 2. La deuxième tension V2 est représentée à la figure 6 par une sixième courbe 312. Cependant, dans cette variante, une entrée analogique numérique supplémentaire est nécessaire, ce qui engendre un surcoût dans le choix du processeur 58.

Dans une autre variante, afin de réaliser l'étape 117 on compare la deuxième tension de référence Vref avec une troisième tension V3 mesurée en sortie du régulateur 51 et alimentant l'unité de traitement 48. La troisième tension V3 est représentée à la figure 6 par une septième courbe 314. Sachant que l'appareil auxiliaire 24 comprend l'organe de stockage 52, le temps de détection de la chute de la tension V3 est long, par exemple, de l'ordre de 40 à 50 ms puisqu'il dépend du temps de décharge de l'organe de stockage 52.

Grâce à l'invention, il est possible de connaitre la cause de la perte de tension en aval du disjoncteur 22 de manière fiable grâce au capteur de courant 44 et au traitement des valeurs de courant I mesurées. Ainsi, grâce à la mesure du courant I, l'application de détermination 66 est propre à déterminer si la perte de tension en aval du disjoncteur 22 est due à un courant de court-circuit traversant le conducteur 12, ou à cause d'un courant de surcharge traversant le conducteur 12, ou encore à une ouverture manuelle ou à une coupure ou chute de la tension sur les bornes d'entrée 34, 36 du disjoncteur 22.

Dans la variante présentée précédemment où, l'appareil auxiliaire 24 comprend un capteur de courant supplémentaire propre à mesurer le courant traversant le deuxième conducteur 14, l'appareil auxiliaire est propre à déterminer la cause de la perte de tension en aval du disjoncteur en fonction des courants traversant chacun des conducteurs électriques 12, 14. Dans cette variante, les valeurs de courant mesurées par chaque capteur de courant sont traitées séparément et le procédé de détermination de la perte de tension en aval du disjoncteur 22 est globalement le même que celui présenté précédemment, à la différence que ce procédé est exécuté pour chaque conducteur électrique 12, 14. Puis, le concentrateur 20 est propre à déterminer la cause de la perte de tension en aval du disjoncteur et sur quel conducteur électrique 12, 14 est apparu un défaut électrique dans le cas où la cause de la perte de tension en aval est une surcharge ou un court-circuit.

En variante, le disjoncteur est associé à un moyen de déclenchement différentiel et le capteur de courant différentiel permet de mesurer le taux de fuite du disjoncteur 22 et d'émettre une alarme à destination du concentrateur de données 20 en cas de risque de déclenchement différentiel du moyen de déclenchement différentiel. De la même manière, le capteur de courant différentiel permet de déterminer si le déclenchement a été commandé par le déclencheur différentiel.

La figure 7 illustre un deuxième mode de réalisation de l'invention pour lequel les éléments analogues au premier mode de réalisation, décrit précédemment, sont repérés par des références identiques, et ne sont pas décrits à nouveau.

Selon le deuxième mode de réalisation, le courant circulant dans la liaison électrique 16 est un courant triphasé, et la liaison électrique 16 comporte trois conducteurs électriques de phase 12 et un conducteur électrique de neutre 14.

Le système électrique 10 comporte alors quatre disjoncteurs 22, formant un disjoncteur tétrapolaire, couplés à l'appareil auxiliaire 20.

L'appareil auxiliaire 20 comporte alors trois capteurs de courant de phase 44, chaque capteur de courant de phase 44 étant associé à un conducteur de phase 12 respectif.

L'application de détermination 66 est alors propre à déterminer la cause de la perte de tension en aval du disjoncteur détectée sur l'un des quatre pôles du disjoncteur 22 en fonction de chacune des intensités mesurées par les capteurs de courant de phase 44.

Le fonctionnement de ce deuxième mode de réalisation pour chaque conducteur de phase 12 est analogue à celui du premier mode de réalisation décrit pour un seul conducteur de phase 12, et n'est pas décrit à nouveau.

Les avantages de ce deuxième mode de réalisation sont identiques à ceux du premier mode de réalisation.

Plus généralement, l'invention s'applique aussi bien à un disjoncteur monophasé propre à être connecté à un conducteur de phase et à un conducteur de neutre, comme présenté dans le premier mode de réalisation, qu'à un disjoncteur triphasé propre à être connecté à trois conducteurs de phases ou encore qu'à un disjoncteur tétrapolaire connecté à trois conducteurs de phase et à un conducteur de neutre, comme présenté dans le deuxième mode de réalisation. Pour les disjoncteurs monophasé et tétrapolaire, lors de l'ouverture du disjoncteur, suivant l'application considérée, le conducteur de neutre est coupé et le courant le traversant est interrompu, ou bien le conducteur de neutre n'est pas coupé et le courant le traversant n'est pas interrompu.

## Revendications

1. Procédé de détermination d'une cause de perte de tension en aval d'un disjoncteur (22) à l'aide d'un appareil auxiliaire (24), la perte de tension en aval correspondant à une ouverture du disjoncteur (22) ou à une chute de tension en entrée du disjoncteur (22) en dessous d'une première valeur de tension de référence, le disjoncteur (22) étant, en position ouverte, propre à interrompre la circulation d'un courant électrique (I) dans une liaison électrique (16) comportant au moins un conducteur électrique (12, 14),
l'appareil auxiliaire comprenant au moins un capteur (44) de courant propre à mesurer l'intensité du courant (I) circulant dans un conducteur électrique (12, 14) respectif et un premier moyen (59) de détection propre à détecter la perte de tension en aval du disjoncteur,
le procédé comprenant les étapes suivantes :
- a) la mesure (102), par le ou chaque capteur (44) de courant, de l'intensité du courant (I) circulant dans le ou chaque conducteur électrique (12, 14),
- b) la détection (117), via le premier moyen de détection (59), de la perte de tension en aval du disjoncteur électrique (22),
le procédé étant **caractérisé en ce qu'**il comprend en outre l'étape suivante :
- c) la détermination (120, 122, 126, 128, 130), par l'appareil auxiliaire (24) et en fonction de l'intensité mesurée par le ou chaque capteur de courant (44), d'une cause de perte de tension en aval du disjoncteur détectée, ladite cause étant de préférence choisie parmi le groupe consistant en : une surcharge électrique, un court-circuit, et une chute de tension.

2. Procédé selon la revendication 1, **caractérisé en ce que** suite à l'étape a) de mesure (102) et précédemment à l'étape b) de détection (117), l'appareil auxiliaire réalise l'étape suivante :
- a2) le calcul (108), en fonction des valeurs d'intensité mesurées à l'étape a), d'un échauffement (θ) d'un ou de deuxièmes moyens de détection d'une surcharge électrique, le ou les deuxièmes moyens de détection étant compris dans le disjoncteur.

3. Procédé selon la revendication 2, **caractérisé en ce que** suite à l'étape a2) l'appareil auxiliaire réalise les étapes suivantes :
- a3) la comparaison (112) de la valeur de l'échauffement (θ) calculée avec une première valeur de seuil (S1), et
- a4) la génération (116) d'un signal d'alarme lorsque la valeur de l'échauffement (θ) calculée est supérieure à la première valeur de seuil (S1).

4. Procédé selon la revendication 2, **caractérisé en ce que** suite à l'étape a2) l'appareil auxiliaire réalise les étapes suivantes :
- a3') la comparaison (112) de la valeur de l'échauffement (θ) calculée avec une première valeur de seuil (S1) et avec une deuxième valeur de seuil (S2), inférieure à la première valeur de seuil (S1), et
- a4') la génération d'un signal d'alarme à partir du moment où la valeur de l'échauffement (θ) calculée est supérieure à la première valeur de seuil (S1) et tant que la valeur de l'échauffement (θ) calculée est supérieure à la deuxième valeur de seuil (S2).

5. Procédé selon les revendications 3 ou 4, **caractérisé en ce que** suite à l'étape b) de détection (117), si la perte de tension en aval du disjoncteur (22) a été détectée par le premier moyen de détection (59), l'appareil auxiliaire réalise au cours de l'étape c) de détermination l'étape suivante :
- c1) la comparaison (126) de la valeur de l'échauffement (θ) calculée avec une troisième valeur de seuil (S3) afin de détecter une première cause de la perte de tension en aval du disjoncteur, la troisième valeur de seuil (S3) étant supérieure à la première valeur de seuil (S1).

6. Procédé selon l'une des revendications précédentes, **caractérisé en ce que** suite à l'étape a) de mesure (102) et précédemment à l'étape b) de détection (117), l'appareil auxiliaire réalise l'étape suivante :
- a5) le calcul d'une valeur maximale (Imax) des intensités (I) mesurées pendant un laps de temps (T1) prédéterminé.

7. Procédé selon la revendication 6, **caractérisé en ce que** suite à l'étape b) de détection (117), si la perte de tension en aval du disjoncteur (22) a été détectée par le premier moyen de détection (59), l'appareil auxiliaire (24) réalise au cours de l'étape c) de détermination l'étape suivante :
- c2) la comparaison (120) de la valeur maximale du courant (Imax) avec une quatrième valeur de seuil (S4), afin de détecter une deuxième cause de la perte de tension en aval du disjoncteur.

8. Procédé selon l'une des revendications précédentes, **caractérisé en ce que** suite à l'étape c) de détermination, l'appareil auxiliaire (24) effectue l'étape suivante :
- d) la transmission (124) d'un message contenant une première donnée (STATUT) correspondant à la présence de tension en aval du disjoncteur et une deuxième donnée (DEFAUT) correspondant à la cause de la perte de tension en aval du disjoncteur (22), vers un concentrateur (20).

9. Appareil auxiliaire (24) pour disjoncteur électrique (22), le disjoncteur étant, en position ouverte, propre à interrompre la circulation d'un courant (I) électrique dans une liaison électrique (16) comportant au moins un conducteur électrique (12, 14),
l'appareil auxiliaire (24) comprenant au moins un capteur (44) de courant propre à mesurer l'intensité du courant (I) circulant dans un conducteur électrique (12, 14) respectif et un premier moyen de détection (59) propre à détecter une perte de tension en aval du disjoncteur (22), la perte de tension en aval correspondant à une ouverture du disjoncteur (22) ou à une chute de tension en entrée du disjoncteur (22) en dessous d'une première valeur de tension de référence,
**caractérisé en ce que** l'appareil auxiliaire (24) comprend un dispositif (66) de détermination d'une cause de la perte de tension en aval du disjoncteur (22), en fonction de l'intensité (I) mesurée par le ou chaque capteur de courant (44),
ladite cause étant de préférence choisie parmi le groupe consistant en : une surcharge électrique, un court-circuit, et une chute de tension.

10. Appareil auxiliaire selon la revendication 9, le disjoncteur (22) comportant une borne d'entrée (34, 36) du courant et une borne de sortie (38, 40) du courant pour chaque conducteur électrique (12, 14), **caractérisé en ce que** le premier moyen de détection (59) comprend au moins un capteur (46) de tension propre à mesurer la tension (V1) délivrée à une borne de sortie (38, 40) respective du disjoncteur (22), et **en ce que** le premier moyen de détection (59) est propre à détecter la perte de tension en aval du disjoncteur (22) si la tension (V1) mesurée par le capteur de tension est inférieure à une deuxième valeur de tension de référence pendant un intervalle de temps (T2) prédéterminé.

11. Appareil auxiliaire selon la revendication 9, le disjoncteur (22) comportant une borne d'entrée (34, 36) du courant et une borne de sortie (38, 40) du courant pour chaque conducteur électrique (12, 14), **caractérisé en ce que** le premier moyen de détection (59) comprend au moins un capteur (46) de tension propre à mesurer la tension (V1) délivrée à une borne de sortie (38, 40) respective du disjoncteur (22), et **en ce que** le premier moyen de détection (59) est propre à calculer une dérivée de la tension mesurée et à détecter la perte de tension en aval du disjoncteur (22) si la dérivée calculée par le premier moyen de détection (59) est inférieure à une valeur de référence pendant un temps de référence (T3) prédéterminé.

12. Appareil auxiliaire selon l'une des revendications 9 à 11, **caractérisé en ce que** le disjoncteur (22) comprend au moins un deuxième moyen de détection propre à détecter une surcharge électrique, et **en ce que** l'appareil auxiliaire (24) comprend un premier moyen de calcul (62) propre à calculer un échauffement (θ) du ou de chaque deuxième moyen de détection, en fonction de l'intensité (I) mesurée par le ou chaque capteur de courant (44), le dispositif de détermination (66) étant propre à déterminer la cause de la perte de tension en aval du disjoncteur (22) en fonction dudit échauffement (θ) calculé.

13. Appareil auxiliaire selon l'une des revendications 9 à 12, **caractérisé en ce que** l'appareil auxiliaire (24) comprend un deuxième moyen de calcul (64) propre à calculer une valeur maximale (Imax) des intensités (I) mesurées pendant un laps de temps (T1) prédéterminé, le dispositif de détermination (66) étant propre à déterminer la cause de la perte de tension en aval du disjoncteur en fonction de la valeur maximale (Imax) des intensités mesurées.

14. Appareil auxiliaire selon la revendication 10 ou 11, **caractérisé en ce que** l'appareil auxiliaire (24) comprend un troisième moyen de calcul propre à calculer une puissance électrique et une énergie électrique traversant chaque conducteur (12, 14) correspondant à partir des valeurs d'intensité (I) et de tension (V1) mesurées par respectivement le ou chaque capteur de courant (44) et le ou chaque capteur de tension (46), et **en ce que** l'appareil auxiliaire (24) comprend un organe de communication (53) propre à transmettre les valeurs d'intensité (I) et de tension (V1) mesurées et les valeurs d'énergie et de puissance calculées vers un concentrateur (20).

15. Système électrique (10) comprenant un disjoncteur électrique (22) et un appareil auxiliaire (24) couplé électriquement au disjoncteur électrique (22), le disjoncteur électrique étant, en position ouverte, propre à interrompre la circulation d'un courant électrique dans une liaison électrique (16) comportant au moins un conducteur électrique (12, 14), **caractérisé en ce que** l'appareil auxiliaire (24) est conforme à l'une quelconque des revendications 9 à 14.

## Patentansprüche

1. Verfahren zum Bestimmen der Ursache eines Spannungsverlusts hinter einem Unterbrecher (22) mit Hilfe einer Zusatzvorrichtung (24), wobei der stromabwärtige Spannungsverlust einem Öffnen des Unterbrechers (22) oder einem Spannungsabfall am Eingang des Unterbrechers (22) unter einen ersten Referenzspannungswert entspricht, wobei der Unterbrecher (22) in der geöffneten Stellung den Fluss eines elektrischen Stroms (I) in einer elektrischen Verbindung (16), die wenigstens einen elektrischen Leiter (12, 14) enthält, unterbrechen kann,
wobei die Zusatzvorrichtung wenigstens einen Stromsensor (44), der die Stärke des in dem jeweiligen elektrischen Leiter (12, 14) fließenden Stroms (I) messen kann, und ein erstes Detektionsmittel (59), das den Spannungsverlust hinter dem Unterbrecher detektieren kann, enthält,
wobei das Verfahren die folgenden Schritte umfasst:
a) Messen (102) der Stärke des in dem oder in jedem elektrischen Leiter (12, 14) fließenden Stroms (I) durch den oder jeden Stromsensor (44),
b) Detektieren (117) des Spannungsabfalls hinter dem elektrischen Unterbrecher (22) über das erste Detektionsmittel (59),
wobei das Verfahren **dadurch gekennzeichnet ist, dass** es außerdem den folgenden Schritt umfasst:
c) Bestimmen (120, 122, 126, 128, 130) durch die Zusatzvorrichtung (24) und als Funktion der Stärke, die von dem oder jedem Stromsensor (44) gemessen wird, einer Ursache des detektierten Spannungsverlusts hinter dem Unterbrecher, wobei die Ursache vorzugsweise aus der Gruppe gewählt wird, die besteht aus: einer elektrischen Überlast, einem Kurzschluss und einem Spannungsabfall.

2. Verfahren nach Anspruch 1, **dadurch gekennzeichnet, dass** nach dem Schritt a) des Messens (102) und vor dem Schritt d) des Detektierens (119) die Zusatzvorrichtung den folgenden Schritt ausführt::
a2) Berechnen (108) einer Erwärmung (θ) eines oder zweier Detektionsmittel einer elektrischen Überlast als Funktion der im Schritt a) gemessenen Stärkewerte, wobei das eine oder die zwei Detektionsmittel in dem Unterbrecher enthalten sind.

3. Verfahren nach Anspruch 2, **dadurch gekennzeichnet, dass** die Zusatzvorrichtung nach dem Schritt a2) die folgenden Schritte ausführt:
a3) Vergleichen (112) des berechneten Erwärmungswertes (θ) mit einem ersten Schwellenwert (S1) und
a4) Erzeugen (116) eines Alarmsignals, wenn der berechnete Erwärmungswert (θ) größer als der erste Schwellenwert (S1) ist.

4. Verfahren nach Anspruch 2, **dadurch gekennzeichnet, dass** die Zusatzvorrichtung nach dem Schritt a2) die folgenden Schritte ausführt:
a3') Vergleichen (112) des berechneten Erwärmungswertes (θ) mit einem ersten Schwellenwert (S1) und mit einem zweiten Schwellenwert (S2), der kleiner als der erste Schwellenwert (S1) ist, und
a4') Erzeugen eines Alarmsignals ab dem Zeitpunkt, zu dem der berechnete Erwärmungswert (θ) größer als der erste Schwellenwert (S1) ist, und solange der berechnete Erwärmungswert (θ) größer als der zweite Schwellenwert (S2) ist.

5. Verfahren nach den Ansprüchen 3 oder 4, **dadurch gekennzeichnet, dass** nach dem Schritt b) des Detektierens (117) dann, wenn der Spannungsverlust hinter dem Unterbrecher (22) durch das erste Detektionsmittel (59) detektiert worden ist, die Zusatzvorrichtung während des Schrittes c) des Bestimmens den folgenden Schritt ausführt:
c1) Vergleichen (126) des berechneten Erwärmungswertes (θ) mit einem dritten Schwellenwert (S3), um eine erste Ursache des Spannungsverlusts hinter dem Unterbrecher zu detektieren, wobei der dritte Schwellenwert (S3) größer als der erste Schwellenwert (S1) ist.

6. Verfahren nach einem der vorhergehenden Ansprüche, **dadurch gekennzeichnet, dass** die Zusatzvorrichtung nach dem Schritt a) des Messens (102) und vor dem Schritt b) des Detektierens (117) den folgenden Schritt ausführt:
a5) Berechnen eines ersten Maximalwerts (Imax) der Stärken (I), die während eines vorgegebenen Zeitraums (T1) gemessen werden.

7. Verfahren nach Anspruch 6, **dadurch gekennzeichnet, dass** nach dem Schritt b) des Detektierens (117) dann, wenn die Spannung hinter dem Unterbrecher (22) durch das erste Detektionsmittel (59) detektiert worden ist, die Zusatzvorrichtung (24) während des Schrittes (c) des Bestimmens den folgenden Schritt ausführt:
c2) Vergleichen (120) des maximalen Stromwerts (Imax) mit einem vierten Schwellenwert (S4), um eine zweite Ursache des Spannungsverlusts hinter dem Unterbrecher zu detektieren.

8. Verfahren nach einem der vorhergehenden Ansprüche, **dadurch gekennzeichnet, dass** die Zusatzvorrichtung (24) nach dem Schritt c) des Bestimmens den folgenden Schritt ausführt:
d) Übertragen (124) einer Nachricht, die erste Daten (STATUT), die dem Vorhandensein einer Spannung hinter dem Unterbrecher entsprechen, und zweite Daten (DEFAUT), die der Ursache des Spannungsverlusts hinter dem Unterbrecher (22) entsprechen, enthält, zu einem Netzverteiler (20).

9. Zusatzvorrichtung (24) für einen elektrischen Unterbrecher (22), wobei der Unterbrecher in der offenen Stellung den Fluss eines elektrischen Stroms (I) in einer elektrischen Verbindung (16), die wenigstens einen elektrischen Leiter (12, 14) enthält, unterbrechen kann,
wobei die Zusatzvorrichtung (24) wenigstens einen Stromsensor (44) enthält, der die Stärke des Stroms (I), der in einem jeweiligen elektrischen Leiter (12, 14) fließt, messen kann, und ein erstes Detektionsmittel (59) enthält, das einen Spannungsverlust hinter dem Unterbrecher (22) detektieren kann, wobei der stromabwärtige Spannungsverlust einem Öffnen des Unterbrechers (22) oder einem Spannungsabfall am Eingang des Unterbrechers (22) unter einen ersten Referenzspannungswert entspricht,
**dadurch gekennzeichnet, dass** die Zusatzvorrichtung (24) eine Vorrichtung (66) zum Bestimmen einer Ursache des Spannungsverlusts hinter dem Unterbrecher (22) als Funktion der von dem oder jedem Stromsensor (54) gemessenen Stärke (I) umfasst,
wobei die Ursache vorzugsweise aus der Gruppe gewählt wird, die besteht aus: einer elektrischen Überlast, einem Kurzschluss und einem Spannungsabfall.

10. Zusatzvorrichtung nach Anspruch 9, wobei der Unterbrecher (22) einen Stromeingangsanschluss (34, 36) und einen Stromausgangsanschluss (38, 40) für jeden elektrischen Leiter (12, 14) umfasst, **dadurch gekennzeichnet, dass** das erste Detektionsmittel (59) wenigstens einen Spannungssensor (46) umfasst, der die an einen jeweiligen Ausgangsanschluss (38, 40) des Unterbrechers (22) gelieferte Spannung (V1) messen kann, und dass das Detektionsmittel (59) den Spannungsverlust hinter dem Unterbrecher (22) detektieren kann, falls die von dem Spannungssensor gemessene Spannung (V1) während eines vorgegebenen Zeitintervalls (T2) niedriger als ein zweiter Referenzspannungswert ist.

11. Zusatzvorrichtung nach Anspruch 9, wobei der Unterbrecher (22) einen Stromeingangsanschluss (34, 36) und einen Stromausgangsanschluss (38, 40) für jeden elektrischen Leiter (12, 14) umfasst, **dadurch gekennzeichnet, dass** das erste Detektionsmittel (59) wenigstens einen Spannungssensor (46) umfasst, der die an einen jeweiligen Ausgangsanschluss (38, 40) des Unterbrechers (22) gelieferte Spannung (V1) messen kann, und dass das erste Detektionsmittel (59) eine Ableitung der gemessenen Spannung berechnen kann und den Spannungsverlust hinter dem Unterbrecher (22) detektieren kann, falls die von dem ersten Detektionsmittel (59) berechnete Ableitung während einer vorgegebenen Referenzzeit (T3) kleiner als ein Referenzwert ist.

12. Zusatzvorrichtung nach einem der Ansprüche 9 bis 11, **dadurch gekennzeichnet, dass** der Unterbrecher (22) wenigstens ein zweites Detektionsmittel umfasst, das eine elektrische Überlast detektieren kann, und dass die Zusatzvorrichtung (24) ein erstes Rechenmittel umfasst, das eine Erwärmung (θ) des oder jedes zweiten Detektionsmittels als Funktion der von dem oder jedem Stromsensor (44) gemessenen Stärke (I) berechnen kann, wobei die Bestimmungsvorrichtung (66) die Ursache des Spannungsverlusts hinter dem Unterbrecher (22) als Funktion der berechneten Erwärmung (θ) bestimmen kann.

13. Zusatzvorrichtung nach einem der Ansprüche 9 bis 12, **dadurch gekennzeichnet, dass** die Zusatzvorrichtung (24) ein zweites Rechenmittel (64) umfasst, das einen Maximalwert (Imax) der während eines vorgegebenen Zeitraums (T1) berechneten Stärken (I) berechnen kann, wobei die Bestimmungsvorrichtung (66) die Ursache des Spannungsverlusts hinter dem Unterbrecher als Funktion des Maximalwerts (Imax) der gemessenen Stärken bestimmen kann.

14. Zusatzvorrichtung nach Anspruch 10 oder 11, **dadurch gekennzeichnet, dass** die Zusatzvorrichtung (24) ein drittes Rechenmittel umfasst, das eine elektrische Leistung und eine elektrische Energie, die durch jeden entsprechenden Leiter (12, 14) laufen, anhand der von dem oder jedem Stromsensor (44) bzw. dem oder jedem Spannungssensor (46) gemessenen Werte der Stärke (I) und der Spannung (V1) berechnen kann und dass die Zusatzvorrichtung (24) ein Kommunikationsorgan (53) umfasst, das die gemessenen Werte der Stärke (I) und der Spannung (V1) und die berechneten Werte der Energie und der Leistung an einen Netzverteiler (20) übertragen kann.

15. Elektrisches System (10), das einen elektrischen Unterbrecher (22) und eine Zusatzvorrichtung (24), die mit dem elektrischen Unterbrecher (22) elektrisch gekoppelt ist, umfasst, wobei der elektrische Unterbrecher in der offenen Stellung den Fluss eines elektrischen Stroms in einer elektrischen Verbindung (16), die wenigstens einen elektrischen Leiter (12, 14) aufweist, unterbrechen kann, **dadurch gekennzeichnet, dass** die Zusatzvorrichtung (24) wie in einem der Ansprüche 9 bis 14 beschaffen ist.

## Claims

1. A method for determining a cause of a voltage drop load-side from a circuit breaker (22) by means of an auxiliary unit (24), the load-side voltage drop corresponding to an opening of the circuit breaker (22) or to a voltage drop at the input of the circuit breaker (22) below a first reference voltage value, the circuit breaker (22) being in an open position able to interrupt the flow of an electric current (I) in an electric connection (16) including at least one electric conductor (12, 14),
the auxiliary unit comprising at least one current sensor (44) able to measure the intensity of the current (I) flowing in a respective electric conductor (12, 14) and a first detection means (59) able to detect the voltage drop load-side from the circuit breaker,
the method comprising the following steps:
- a) measuring (102), with said or each current sensor (44), the intensity of the current (I) flowing in said or each electric conductor (12, 14),
- b) detecting (117), via the first detection means (59), the voltage drop load-side from the electric circuit breaker (22),
the method being **characterized in that** it further comprises the following step:
- c) determining (120, 122, 126, 128, 130), with the auxiliary unit (24) and depending on the intensity measured by said or each current sensor (44), a cause of a detected voltage drop load-side from the circuit breaker, said cause being preferably selected from the group consisting in: an electric overload, a short-circuit and a voltage drop.

2. The method according to claim 1, **characterized in that**, subsequently to the measurement step a) (102) and preceding the detection step b) (117), the auxiliary unit carries out the following step:
- a2) calculating (108), depending on the intensity values measured in step a), a heating-up (θ) of one or second detection means of an electric overload, the second detection means being comprised in the circuit breaker.

3. The method according to claim 2, **characterized in that**, subsequently to step a2), the auxiliary unit carries out the following steps:
- a3) comparing (112) the value of the heating-up (θ) calculated with a first threshold value (S1), and
- a4) generating (116) an alarm signal when the value of the calculated heating-up (θ) is greater than the first threshold value (S1).

4. The method according to claim 2, **characterized in that**, subsequently to step a2), the auxiliary unit carries out the following steps:
- a3') comparing (112) the value of the heating-up (θ) calculated with a first threshold value (S1) and with a second threshold value (S2), less than the first threshold value (S1), and
- a4') generating an alarm signal from the moment when the calculated heating-up (θ) value is greater than the first threshold value (S1) and as long as the calculated value of the heating-up (θ) is greater than the second threshold value (S2).

5. The method according to claim 3, **characterized in that**, subsequently to the detection step b) (117), if the voltage drop load-side from the circuit breaker (22) was detected by the first detection means (59), the auxiliary unit carries out during the determination step c), the following step:
- c1) comparing (126) the calculated value of the heating-up (θ) with a third threshold value (S3) in order to detect a first cause of the voltage drop load-side from the circuit breaker, the third threshold value (S3) being greater than the first threshold value (S1).

6. The method according to claim 1, **characterized in that**, subsequently to the measurement step a) (102) and preceding the detection step b) (117), the auxiliary unit carries out the following step:
- a5) calculating a maximum value (Iₘₐₓ) of the measured intensities (I) during a predetermined lapse of time (T1).

7. The method according to claim 6, **characterized in that**, subsequently to the detection step b) (117), if the voltage drop load-side from the circuit breaker (22) has been detected by the first detection means (59), the auxiliary unit (24) during the determination step c) carries out the following step:
- c2) comparing (120) the maximum value of the current (Iₘₐₓ) with a fourth threshold value (S4), in order to detect a second cause of the voltage drop load-side from the circuit breaker.

8. The method according to any of the preceding claims, **characterized in that**, subsequently to the determination step c), the auxiliary unit (24) carries out the following step:
- d) transmitting (124) a message containing a first datum (STATUS) corresponding to the presence of a voltage load-side from the circuit breaker and a second datum (DEFAULT) corresponding to the cause of the voltage drop load-side from the circuit breaker (22), to a concentrator (20).

9. An auxiliary unit (24) for an electric circuit breaker (22), the circuit breaker being, in the open position, capable of interrupting the flow of an electric current (I) in an electric connection (16) including at least one electric conductor (12, 14),
the auxiliary unit (24) comprising at least one current sensor (44) able to measure the intensity of the current (I) flowing in a respective electric conductor (12, 14) and a first detection means (59) able to detect a voltage drop load-side from the circuit breaker (22), the load-side voltage drop corresponding to an opening of the circuit breaker (22) or to a voltage drop at the input of the circuit breaker (22) below a first reference voltage value,
**characterized in that** the auxiliary unit (24) comprises a device (66) for determining a cause of the voltage drop load-side from the circuit breaker (22), depending on the intensity (I) measured by said or each current sensor (44),
said cause being preferably selected from the group consisting in: an electric overload, a short-circuit and a voltage drop.

10. The auxiliary unit according to claim 9, the circuit breaker (22) including an input terminal (34, 36) for the current and an output terminal (38, 40) for the current for each electric conductor (12, 14), **characterized in that** the first detection means (59) comprises at least one voltage sensor (46) able to measure the voltage (V1) delivered to a respective output terminal (38, 40) of the circuit breaker (22), and **in that** the first detection means (59) is able to detect the voltage drop load-side from the circuit breaker (22) if the voltage (V1) measured by the voltage sensor is less than a second reference voltage value during a predetermined time interval (T2).

11. The auxiliary unit according to claim 9, the circuit breaker (22) including an input terminal (34, 36) for the current and an output terminal (38, 40) for the current for each electric conductor (12, 14), **characterized in that** the first detection means (59) comprises at least one voltage sensor (46) able to measure the voltage (V1) delivered to a respective output terminal (38, 40) of the circuit breaker (22), and **in that** the first detection means (59) is able to calculate a derivative of the measured voltage and to detect the voltage drop load-side from the circuit breaker (22) if the derivative calculated by the first detection means (59) is less than a reference value during a predetermined reference time (T3).

12. The auxiliary unit according to claim 9, **characterized in that** the circuit breaker (22) comprises at least a second detection means able to detect an electric overload, and **in that** the auxiliary unit (24) comprises a first calculation means (62) able to calculate a heating-up value (θ) of said or each second detection means, depending on the intensity (I) measured by said or each current sensor (44), the determination device (66) being able to determine the cause of the voltage drop load-side from the circuit breaker (22) depending on said calculated heating-up value (θ).

13. The auxiliary unit according to claim 9, **characterized in that** the auxiliary unit (24) comprises a second calculation means (64) able to calculate a maximum value (Iₘₐₓ) of the intensities (I) measured during a predetermined lapse of time (T1), determination device (66) being able to determine the cause of the voltage drop load-side from the circuit breaker depending on the maximum value (Iₘₐₓ) of the measured intensities.

14. The auxiliary unit according to claim 10, **characterized in that** the auxiliary unit (24) comprises a third calculation means capable of calculating an electric power and an electric energy crossing each corresponding conductor (12, 14) from the intensity (I) and voltage (V1) values respectively measured by said or each current sensor (44) and said or each voltage sensor (46), and **in that** the auxiliary unit (24) comprises a communication member (53) able to transmit the intensity (I) and voltage (V1) measured values and the calculated energy and power values to a concentrator (20).

15. An electric system (10) comprising an electric circuit breaker (22) and an auxiliary unit (24) electrically coupled with the electric circuit breaker (22), the electric circuit breaker being in the open position, able to interrupt the flow of electric current in an electric connection (16) including at least one electric conductor (12, 14), **characterized in that** the auxiliary unit (24) is compliant with any of claims 9 to 14.
